# EUROPEAN PATENT APPLICATION

(11) **EP 1 296 046 A2**
(43) Date of publication of application: **26.03.2003**
(21) Application number: 02256448.8
(22) Date of filing: 17.09.2002
(51) Int. Cl.: F02D 31/00, F02D 41/02, F01D 25/26

(54) **Electronic engine controller**

(30) Priority: 24.09.2001 GB 0122956; 18.10.2001 GB 0125113; 24.12.2001 GB 0130933
(71) Applicant: Lucas Industries Limited, West Midlands B90 4LA (GB)
(72) Inventor: Henson, Nigel Herbert, Norton Lindsey, Warwickshire CV35 8JQ (GB)
(74) Representative: Beck, Simon Antony

(57) **Abstract**

A controller (18) is provided in which an independent protection controller (38) is provided in a casing (8), which casing (8) is disposed within the casing (4) for the main controller (18), such that the protection controller (38) is provided as a box within a box. This allows the casing (4) for the main controller to provide extra protection to the protection controller (38) against mechanical stress and damage. The independent protection module is directly connected to a pilot operated "shut down" demand and in response to such a demand assumes authority to shut the engine down.

## Description

The present invention relates to an electronic engine controller for use in controlling the speed of a gas turbine engine. Furthermore, the engine controller of the present invention is also arranged to implement an emergency shut down procedure in response to a pilot command.

It is known to provide electronic engine controllers (EEC) to control the speed and thrust of gas turbine engines used in an aircraft. These devices are generally very reliable and this reliability is further enhanced by the provision of dual channel redundancy within such controllers.

In spite of the reliability of such controllers, pilots have always sought to control the shut down of the engine by virtue of a cockpit over-ride to the electronic engine controller. This has hitherto been implemented by providing an extra coil on a fuel shut off valve, with the coil being directly linked to the pilot operated control switch. This coil is in addition to those control coils required by the electronic engine controller itself.

The provision of these extra coils brings with it, to some extent, its own risks. Firstly, the number of wires in the wiring harness and number of actuator coils within the system as a whole become increased. This additional complexity gives rise to the possibility of a higher failure rate within the system as a whole. Furthermore the pilot "shut down" command when issued causes an immediate closing at a shut off valve, and whilst this is effective at shutting down the engine, it may cause unnecessary damage or stress on engine components.

According to a first aspect of the present invention, there is provided an electronic engine controller for controlling a gas turbine engine, the controller comprising a main controller and an independent protection device, wherein the independent protection device is responsive to a pilot input for demanding shut down of an engine controlled by the electronic engine controller, and wherein in response to the shut down command being issued, the independent protection device assumes control in order to shut down the engine.

The independent protection device accommodates against various FADEC or engine induced hazards and provides the fuel shut-off control normally required of an electronic engine controller main controller.

It is thus possible to provide an electronic engine controller which is responsible for emergency engine shut down. This contrasts with prior art systems where a pilot operated control has directly energised coils on a shut off valve. The removal of the additional coils and wiring thereto saves both weight and complexity in the shut off system.

Preferably the independent protection device is enclosed within a space which itself is isolated from but enclosed by the casing of the main controller. Thus, by positioning the independent protection device within a casing for the main controller, additional routing of power and data connections to another space in the airframe is avoided. A weight improvement is also achieved since the case for the independent protection device can be thinner, and hence lighter, than would be the case if it was sited outside of the casing of the main engine controller, since the casing of the main engine controller provides physical protection to the independent protection device.

Alternatively the independent protection device may form part of a distributed engine control system and be located on a separate part of the engine remote from the main engine controller.

Preferably the data connections to and from the independent protection device are separate and distinct from those to and from the main controller. This has the advantage that a failure in the main controller, or in one of the sensors thereof cannot be propagated to the independent protection device. Advantageously the independent protection device has a power supply which is independent of the power supply of the main controller. Thus, once again, failure of one supply to the independent protection device or the main controller cannot be propagated to the other of the independent protection device and the main controller.

Advantageously both the independent protection device and the main controller each comprise two channels, such that each device has redundancy. This means that failure of one channel of either device can be tolerated and that normal operation will be continued.

According to a second aspect of the present invention, there is provided an engine fuel system, comprising:
a metering valve for controlling the rate of fuel delivery to a jet engine;
a shut off valve operable to inhibit the supply of fuel to the jet engine; and
an electronic engine controller, the electronic engine controller comprising a primary engine controller and an independent protection device, and wherein the independent protection device is responsive to a shut down command issued from the cockpit of the aircraft, and in response to receipt of a shut down command the independent protection device operates the shut off valve to inhibit the supply of fuel to the engine.

Thus, the shut off valve is responsive to, and only to, the electronic engine controller. Thus the provision of additional coils, with the associated increase in weight and introduction of new failure modes, is avoided.

Advantageously the fuel system further comprises a protection valve which is responsive to the independent protection device for implementing thrust control protection. In response to a shut down command, the independent protection device advantageously operates the protection valve prior to operating the shut off valve such that a more controlled engine shut down can be achieved. This can avoid the induction of high transient pressures within the fuel system of the engine.

Equally the independent protection module may signal the EEC main channel to reduce the flow, prior to it executing a shut-down command, again to avoid high transient pressures during routine engine shut-down with a fully functioning EEC control channel available.

The present invention will further be described, by way of example, with reference to the accompanying drawings, in which:
Figure 1 is a perspective view of an electronic engine controller constituting an embodiment of the present invention;
Figure 2 schematically illustrates the relationship between the control channels of the electronic engine controller and the protection device;
Figure 3 schematically illustrates an embodiment of the present invention in greater detail;
Figure 4 schematically illustrates the casing for the protection device used in combination with the electronic engine controller illustrated in Figure 1;
Figure 5 is a cross-sectional view through the controller of Figure 1;
Figure 6 illustrates a schematic diagram showing interconnections for an engine controller if the shut off is implemented in a "traditional" manner; and
Figure 7 schematically the same engine controller, but where shut down is implemented in accordance with the present invention.

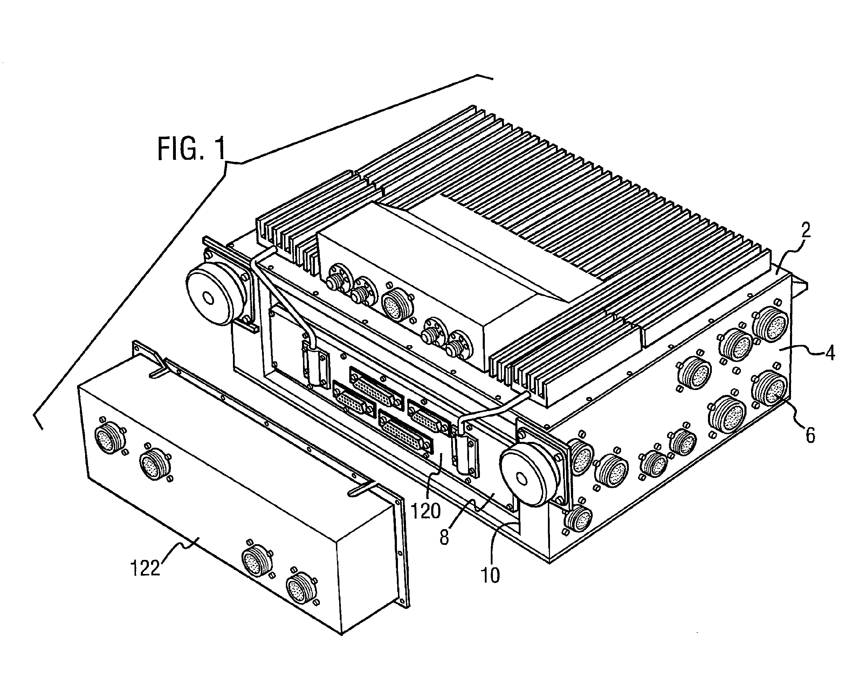

Figure 1 schematically illustrates a full authority digital engine controller module which is suitable for use in an aircraft. The controller 2 comprises a first case 4 which provides a sealed enclosure for the electronics of the engine controller. The thickness of the walls of the casing 4 is selected so as to provide the desired levels of rigidity, resistance to impact, and blast protection deemed appropriate by the designer. Electrical connections between the controller circuitry and the aircraft are made via connectors 6 of types well known to the person skilled in the art.

The case 4 has a closed recess formed therein. That is to say, the recess forms a bay into which an independent protection device can be inserted, but the recess itself does not provide a path between the environment external to the casing 4 and the environment internal to the casing. As shown in Figure 1, an independent protection device enclosed within its own casing 8 is inserted into the recess 10 in the casing 4 in order that the casing 4 surrounds and protects the protection device and its casing 8.

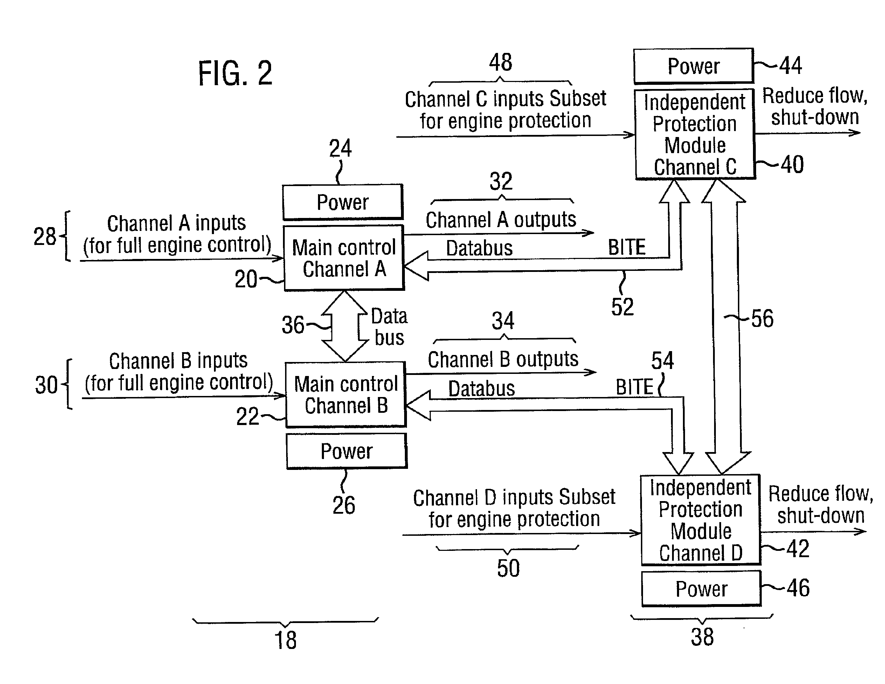

As shown in Figure 2, the controller 18 comprises two main control channels 20 and 22. The first channel 20 has a power supply 24 associated uniquely with it. Similarly, the second channel 22 has a power supply 26 associated uniquely with it. Thus failure of the power supply of either channel does not cause the entire control system to fail. Each of the channels 20 and 22 also has its own set of inputs 28 and 30, which will be described in greater detail hereinafter. The first channel 20 has a plurality of outputs 32 for controlling the various fuel control valves associated with the engine. Similarly, the second channel 22 has an equivalent set of outputs 34 for performing the same task. The channels 20 and 22 are interconnected by a data bus 36 which enables them to exchange data in order that they can confirm that each other channel is working, and monitor the performance of each other's sensors and the like in a manner which is known to the person skilled in the art.

The protection module 38 comprises first and second independent protection channels 40 and 42. The first independent protection channel 40 is associated uniquely with power supply 44, whereas the second independent protection channel 42 has its own power supply 46. These power supplies can be independent or selectively independent, of the power supplies 24 and 26 associated with the first and second channels of the controller. The power supplies may be derived from a permanent magnet alternator, PMA. The PMA has a dedicated winding for each one of the channels 20, 22 of the controller 18, i.e. main control channels A and B, and dedicated windings for each of the channels 40, 42 of the independent protection module 38. Thus there are four separate windings in total. Each winding is fed through its own dedicated connector and harness to the respective individual connectors of the electronic engine controller and the independent protection unit. Thus failure of any one of the power supplies does not affect more than one controller channel or one protection channel. The first protection channel 40 receives a plurality of inputs for monitoring the performance of the engine such that it has sufficient data to perform engine over-speed/over-thrust protection. These inputs are indicated 48 on Figure 2. Similarly a second set of inputs 50 are provided to the second protection channel 42. The inputs also include a "shut off" demand that can be issued from the pilot or co-pilot.

Although the electronics of the protection system 38 is effectively isolated from the electronics of the controller 18, nevertheless it is advantageous to have a limited connection between the systems such that each can monitor, but not influence, the health of the other. Thus limited electrical connection between the first channel 20 of the controller and the first channel 40 of the protection module is provided via a data bus connection 52. Similarly a second data bus connection 54 extends between the second channel 22 of the controller and the second channel 42 of the protection module. The first and second channels 40 and 42 of the protection module also have a data exchange path 56 between the channels, for example, in the form of a serial bus, such that each may monitor the health of the other, and if necessary, can also swap data between the channels.

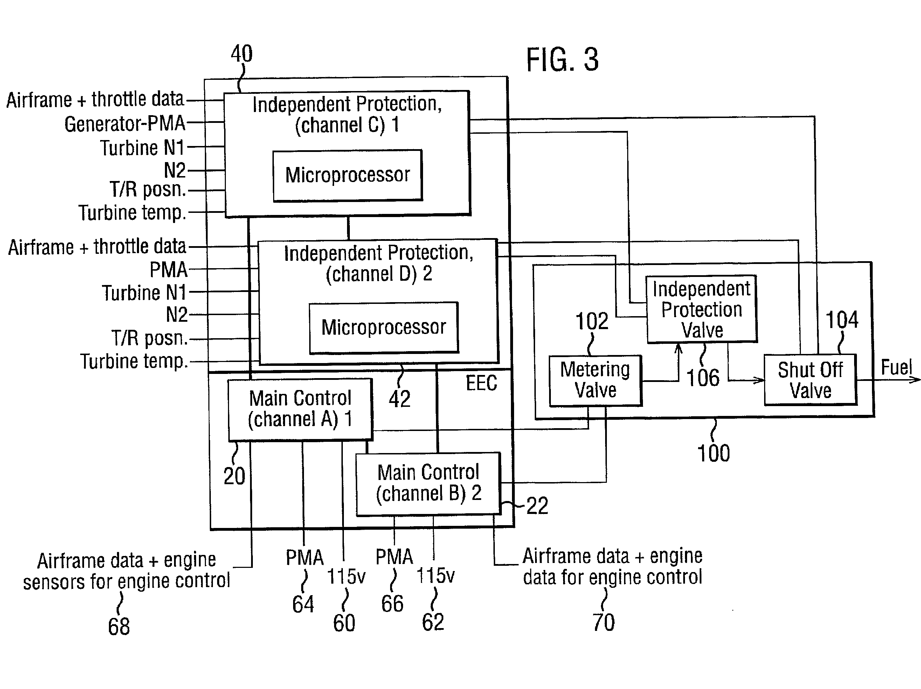

Figure 3 schematically illustrates the interconnection between the electronic engine controller, the various aircraft sensors, and a fuel metering unit which controls the supply of fuel to the gas turbine engine.

Each of the main control channels 20 and 22 receives an independent electrical supply 60 and 62, an independent indication of the speed of an electrical generator associated with the gas turbine engine via inputs 64 and 66, respectively, and a plurality of other input data via data buses 68 and 70, respectively, including pilot throttle position, engine turbine temperature, spool speeds of the various shafts within the engine and so on. These input data to the main control channels may include pilot shut-down signal data, either for management of the EEC functions, or to increase redundancy within the pilot shut-down function.

Each of the control channels 20 and 22 has an output to the fuel metering unit 100. The fuel metering unit regulates the supply of fuel to the gas turbine engine and includes, amongst other things a servo controlled metering and dump valve 102, a shutoff valve 104, and an independent protection valve 106 in series with the metering servo valve 102 for providing additional protection against excess fuel flow rate.

The main controllers 20 and 22 have independent outputs to the servo controlled metering valve 102. In use, either one of the first and second channels 20 and 22 acts as a master controlling the engine speed, whereas the other operates in a standby or "ready but not active" mode.

The invention can also be used to provide engine protection in systems providing multiple metered fuel supplies to separate burners which operate at different engine conditions. These are known as staged combustion systems. For an engine application requiring staged combustion, a more complex metering valve arrangement exists in the fuel metering unit 100, and the independent protection valve 106 will either act on just one of the metered fuel supplies, or on the total metered flow to the engine before it splits into separate flows within the fuel metering unit. In this way the flow is reduced by an acceptable amount to provide engine protection.

Each of the channels 40 and 42 of the independent protection module receives a limited set of data independent from the main control channels sufficient to enable it to fulfil its engine protection tasks and to perform shut down of the engines. The data includes data derived from the aircraft airframe, such as the pilot controlled throttle position, shut down demands and also data derived from the flight control surfaces, such as the high lift surfaces such that the controller can deduce when the aircraft is in relatively low level flight, for example during approach or takeoff, and also optional data from undercarriage sensors such that the independent protection module can deduce when the aircraft is on the runway. Each of the protection channels also receives an indication of engine shaft speeds, turbine temperature, generator speed and thrust reverser position. These inputs are used by a microprocessor based data controller in order to derive appropriate limits for engine speed and thrust, and also to derive what action is to be taken under various circumstances.

Each of the protection devices has independent outputs to the independent protection valve 106 and also to the shut off valve 104.

Depending on the situation, the independent protection module has the ability to either reduce fuel flow to the engine or shut the engine down.

In the event of a thrust control malfunction occurring while the aircraft is on the ground, if both controllers 40 and 42 concur that an over thrust has occurred under these conditions then they also act to shut the engine down. In the event that a thrust control malfunction is detected during an aircraft approach to the runway during the landing procedure then engine shut down is not appropriate but reduction of engine power is and consequently the independent protection valve 106 is operated to modify the fuel flow to the engine.

Furthermore, if the pilot or co-pilot issue the engine shut down demand signal, then either one of the protection modules is capable of operating the shut off valve 104 in order to inhibit the supply of fuel to the engine. The independent protection devices 40 and 42 may, depending on flight conditions, initially operate the independent protection valve 106 in order to reduce the fuel flow, albeit fairly rapidly, before operating the shut off valve 104 in order to provide a more "engineered" shut down. That is, action can be taken to prevent engine damage due to pressure transients or carbonisation of fuel in fuel lines. Alternatively the independent protection module may signal and allow time for the main EEC channels to reduce engine flow before IPM operates shut-down.

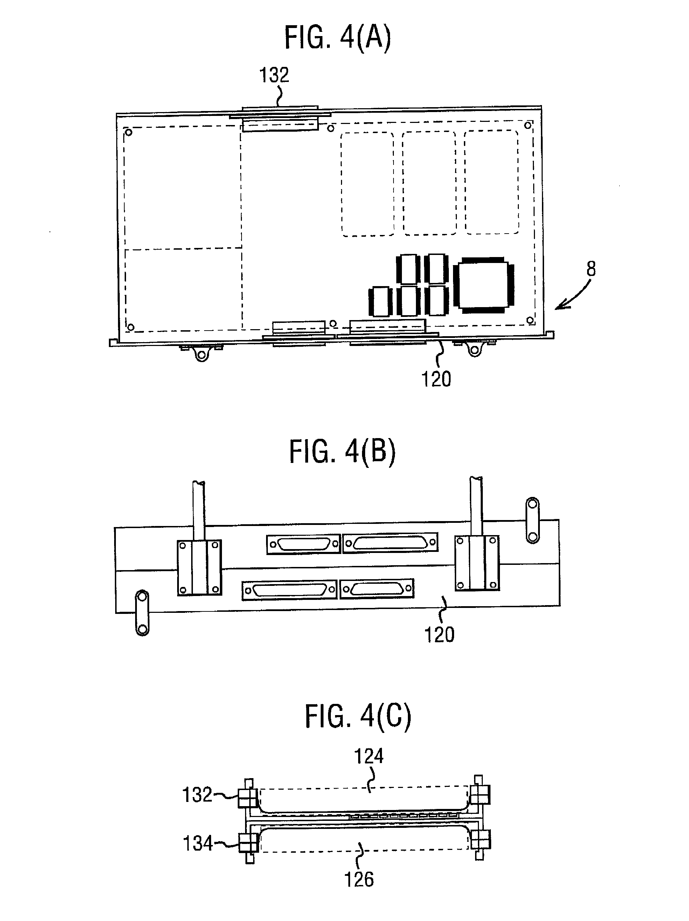

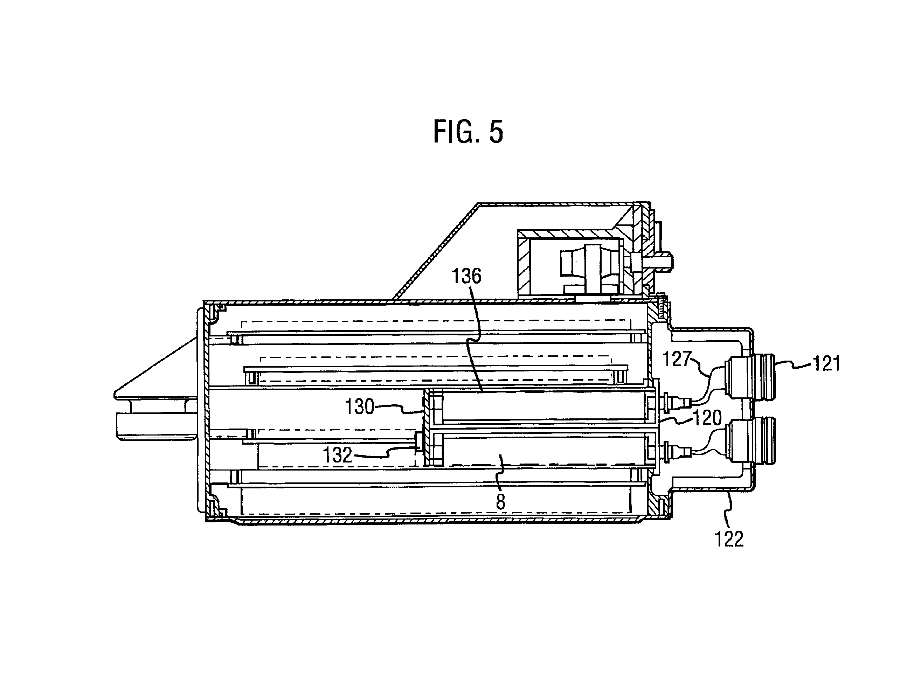

Figure 4 schematically illustrates the arrangement of the casing for the protection modules used in the digital engine controller shown in Figure 1. In particular, Figure 4 shows the casing 8 in both plan view and as viewed from the front end of the casing which forms the panel 120 of connectors shown in Figure 1 and as viewed from the side. Figure 5 shows a side view of the main controller case 4 with a further cover 122 for the independent protection module, which shields the independent protection module in the event of a fire around the case 4 of the controller. Connection extensions 127 run between connectors provided in the panel 120 of the casing and the connectors 121 provided on a cover plate 122 shown in Figure 5. Consequently the spaces 124 and 126 (Figure 4) allocated for the electronics of the first and second protection channels are indeed wholly enclosed within the boundary 136 delimited by the case 4 and none of the walls defining these spaces are in direct contact with the environment surrounding the case 4. As also shown, the inboard face 130 of the casing 8 carries connectors 132 for making the data bus connections to the first and second channels of the primary controller.

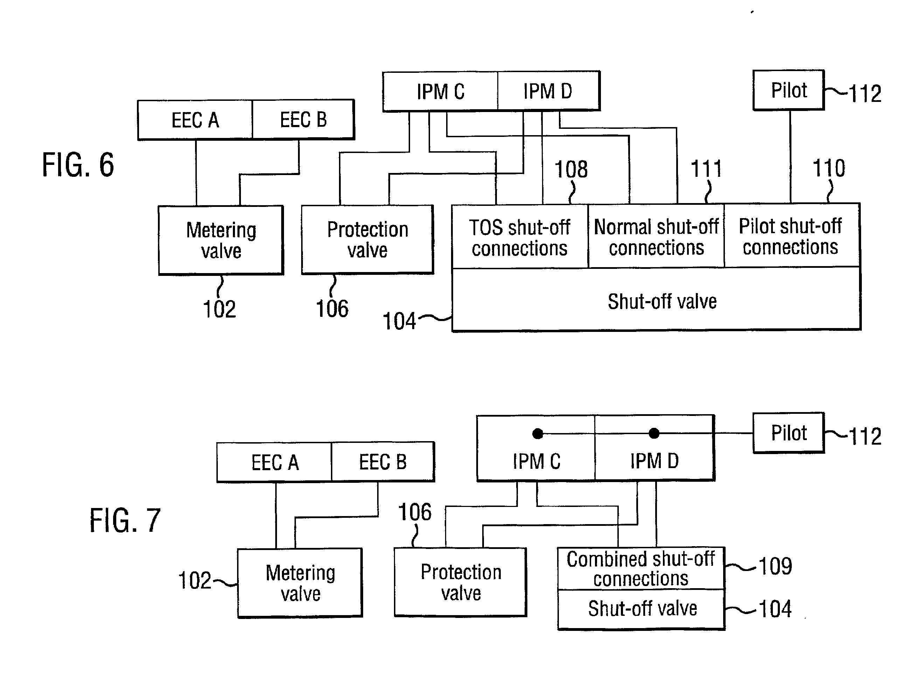

Figures 6 and 7 compare and contrast the configuration of the full authority digital engine controller (FADEC) control valve wiring in accordance with an essentially prior art implementation in which a pilot shut down signal is given directly to the shut-off valve, as shown in Figure 6, and utilises the advantages of the present invention, as shown in Figure 7.

In a prior art implementation, the pilot would have direct connection to a pilot operated shut off valve. Thus, in an embodiment of the present invention (because of the provision of the independent protection devices) in which two primary controllers EEC A and EEC B are provided, each is connected to the metering valve 102. Furthermore, independent protection modules IMP C and IMP D are each connected to the protection valve 106, and would also in an extension of the prior art topology have connections 108 to a shut off valve 104 which would be energised in the event of turbine over speed (TOS). The shut-off valve 104 also has connections 111 to the independent protection modules IPM C and IPM D which are energised/de-energised during normal engine start-up and shut-down. The shut off valve 104 would also directly receive a pilot command from a pilot operated switch 112 via connections 110. Thus, in this configuration nine individual drives would be required requiring ten coils because the pilot shut off signal requires two coils for design integrity.

However, in an embodiment of the present invention as shown in Figure 7, the pilot command is provided directly to the independent protection modules C and D which in turn have direct connections 109 to the shut off valve 104. Thus this arrangement only requires six drives and six coils. This provides an improvement to the system, both in terms of overall weight and in terms of reduced number of possible failure modes.

It is thus possible to provide an electronic engine controller in which the overall weight of the system and number of failure modes is reduced. This is possible because an independent protection module is situated within an independent casing held within the casing of the main engine controller. This "box within a box" concept means that a casing of the main controller can provide mechanical and fire protection for the casing of the independent protection module thereby allowing the second casing to be lighter and less rigid. Thus the casing 8 can have much thinner walls than would be required if it were positioned outside of the controller casing 4. This has advantages in terms of weight of the entire system, and also advantages in terms of routing the data and power connections to the auxiliary/overspeed controller. In order to enhance thermal isolation between the controller and the independent protection module, a gap or a separation box 136 may be provided between the main controller and the independent protection module 8.

## Claims

1. An electronic engine controller for controlling a gas turbine engine, the controller (2) comprising a main controller (18) and an independent protection device (38), wherein the independent protection device (38) is responsive to a pilot input (112) for demanding shut down of an engine controlled by the controller (2), and wherein in response to the shut down command being issued, the independent protection device (38) assumes control to shut down the engine.

2. An electronic engine controller as claimed in claim 1, wherein the independent protection device (38) is enclosed within a space (136) which is isolated from and enclosed by a casing (4) for the main controller.

3. An electronic engine controller as claimed in claim 1 or 2, in which the independent protection device (38) receives data from an associated engine and the aircraft via sensors and inputs (48, 50) which are isolated from the main controller (18).

4. An electronic engine controller as claimed in any one of claims 1 to 3, in which the independent protection device (38) has a power supply which is independent of the main controller (18).

5. An electronic engine controller as claimed in any one of claims 1 to 4, in which the independent protection device (38) comprises two independent data processing channels (40, 42) so as to provide fault tolerance.

6. An electronic engine controller as claimed in any one of the preceding claims, in which the main controller (18) is housed within a first casing (4) and the independent protection device is housed within a second casing (8) which is enclosed by the first casing.

7. An electronic engine controller as claimed in claim 2, wherein the walls of the second casing (8) are thinner than those of the first casing (4).

8. An electronic engine controller as claimed in any one of the preceding claims, in which the independent protection device (38) is located remotely from the main controller (18).

9. An engine fuel system, comprising:
at least one metering valve (102) for controlling the rate of fuel delivery of a jet engine;
a shut off valve (104) operable to inhibit the supply of fuel to the jet engine; and
an electronic engine controller (2), the controller comprising a primary engine controller (18) and an independent protection device (38), and wherein the independent protection device is responsive to a shut down command issued from a cockpit of the aircraft, and in response to receipt of a shut down command the independent protection device (38) operates the shut off valve (104) to inhibit the supply of fuel to the engine.

10. An engine fuel system as claimed in claim 9, wherein the shut down command is supplied solely to the independent protection device (38).

11. An engine fuel system as claimed in claim 9, wherein the shut down signal is supplied to the independent protection device (38) and to the main controller (18).

12. An engine fuel system as claimed in claim 9, 10 or 11, wherein the fuel system further comprises a protection valve (106) responsive to the independent protection device (38) for providing a controlled reduction of the fuel flow, and where, in response to the shut down command, the independent protection device operates the protection valve (106) and the shut off valve (104) in sequence so as to reduce the rate of fuel flow prior to inhibiting fuel flow.

13. An engine fuel system as claimed in claim 9, 10 or 11, wherein the fuel system further comprises a protection valve (106), and where in response to the shut down command, the independent protection device signals the main controller (18) to reduce the fuel flow to the engine prior operating the shut off valve.

14. An engine fuel system as claimed in claim 9, in which in response to receiving a shut down command, the independent protection device (38) signals the main controller to reduce engine fuel flow.

15. An engine fuel system as claimed in any one of claims 9 to 14, in which the primary controller is housed within a first casing (4) and the independent protection device is housed within a second casing (8) enclosed by the first casing.

16. An engine fuel system as claimed in any one of claims 9 to 15, in which the independent protection device is provided to limit engine speed.

17. An engine fuel system as claimed in any one claims 9 to 16, in which the independent protection device (38) has a power supply independent of a power supply to the primary controller.

18. An engine fuel system as claimed in any one of claims 9 to 17, in which the independent protection device (38) receives and sends data independently from the primary controller.

19. An engine fuel system as claimed in any one of claims 9 to 18, in which the primary controller (18) and the independent protection device (38) each have more than one channel therein so as to provide fault tolerance.

20. An engine fuel system as claimed in claim 15, wherein the walls of the second casing (8) are of reduced thickness compared to the walls of the first casing (4).

21. An engine fuel system as claimed in claim 15, in which the independent protection device is inserted into a recess formed in the first casing.
